# EUROPÄISCHE PATENTSCHRIFT

(11) **EP 2 450 952 B1**
(45) Veröffentlichungstag und Bekanntmachung des Hinweises auf die Patenterteilung: **10.08.2016**
(21) Anmeldenummer: 11183244.0
(22) Anmeldetag: 29.09.2011
(51) Int. Cl.: H01L 25/07, H01L 25/18, H01L 23/48, H02M 7/00

(54) **Leistungshalbleitermodul mit einem Substrat mit einer Mehrzahl gleichartig ausgebildeter Leiterbahngruppen**
Semiconductor module with a substrate with a number of identically designed conductor line groups
Module semi-conducteur de puissance doté d'un substrat ayant une multitude de groupes de pistes conductrices développées de manière similaire

(30) Priorität: 04.11.2010 DE 102010043362
(43) Veröffentlichungstag der Anmeldung: 09.05.2012
(73) Patentinhaber: SEMIKRON Elektronik GmbH & Co. KG, 90431 Nürnberg (DE)
(72) Erfinder: Göbl, Christian, 90441 Nürnberg (DE)

(56) Entgegenhaltungen:
- WO-A1-2009/093982
- DE-A1-102004 027 185
- DE-A1-102005 032 965
- JP-A- S62 150 871
- US-A- 5 512 790
- US-A- 5 563 447

## Beschreibung

Die Erfindung beschreibt ein Leistungshalbleitermodul mit mindestens einem Substrat, auf Leiterbahnen dieses Substrats angeordneten Leistungshalbleiterbauelementen und schaltungsgerechten Verbindungseinrichtungen. Derartige Leistungshalbleitermodule weisen gemäß dem allgemein bekannten Stand der Technik eine Vielzahl verschiedener Schaltungstopologien auf. Die bekanntesten sind Halbbrückenschaltungen mit zwei Leistungsschaltern oder Gleichrichterschaltungen mit Leistungsdioden und / oder Leistungsthyristoren.

Aus der nicht vorveröffentlichten DE 10 2009 037 257 A1 ist beispielhaft ein derartiges Leistungshalbleitermodul bekannt. Dieses weist ein Grundplatte und auf dieser angeordnet eine Mehrzahl von Subtraten auf, wobei auf jedem Substrat Leiterbahnen zur schaltungsgerechten Anordnung von Leistungshalbleiterbauelementen vorgesehen sind. Zudem weist dieses Leistungshalbleitermodul Lastanschlusselemente auf, die das Substrat kontaktieren und externe Verbindungseinrichtungen aufweisen. Diese Lastanschlusselemente sind derart ausgebildet, dass sie in einem wesentlichen Abschnitt eng benachbart zueinander verlaufen, um unerwünschte parasitäre Induktivitäten möglichst gering zu halten.

Beispielhaft aus der DE 10 2006 006 425 A1 ist es weiterhin bekannt, das Leistungshalbleitermodul ohne Grundplatte auszubilden und die Lastanschlusselemente durch eine Druckeinrichtung elektrisch leitend mit dem Substrat zu verbinden. Hierzu weisen die bandartig ausgebildeten Lastanschlusselemente einzelne Kontaktfüße auf, die durch Ausnehmungen des Gehäuses zum Substrat hindurchragen. Auch bei dieser Ausgestaltung sind die Lastanschlusselement in einem wesentlichen Abschnitt parallel und eng benachbart zueinander angeordnet.

Aus der JPS 62 150 871 A ist eine Halbleitervorrichtung, bei denen Leistungshalbleiterschalter entlang konzentrischer Kreise angeordnet sind, bekannt.

Aus der DE 10 2004 027 185 A1 ist ein Halbleiterbauelement bekannt, das zwei zu einer Halbbrücke miteinander verschaltete Elemente sowie eine erste, eine zweite und eine dritte Anschlusslasche aufweist, wobei jedes der Elemente der Halbbrücke wenigstens ein, bevorzugt steuerbares, Halbleiterelement umfasst. Die Fusspunkte der Anschlusslaschen sind dabei so angeordnet, dass die Strompfade des Stromes vom Fusspunkt der ersten zur dritten Anschlusslasche möglichst parallel zum Strompfad des Stromes vom Fusspunkt der zweiten zur dritten Anschlusslasche verläuft.

Aus der US 5 512 790 A ist ein Leistungshalbleitermodul mit koaxial angeordneten Lastanschlusselementen bekannt.

Der Erfindung liegt die Aufgabe zugrunde ein Leistungshalbleitermodul vorzustellen, das bei einem kompakten Aufbau eine effiziente Wärmeabgabe zu einer Kühleinrichtung ermöglicht und eine effiziente, mit geringen parasitäten Induktivitäten behaftete interne Stromführung aufweist.

Die Aufgabe wird erfindungsgemäß gelöst durch ein Leistungshalbleitermodul mit den Merkmalen des Anspruchs 1. Bevorzugte Ausführungsformen sind in den abhängigen Ansprüchen beschrieben.

Das erfindungsgemäße Leistungshalbleitermodul weist mindestens ein Substrat zur direkten Anordnung auf einem Kühlkörper oder zur Anordnung auf einer vorzugsweise metallischen Grundplatte auf. Das Substrat bildet den Schaltungsträger der leistungselektronischen Schaltung des Leistungshalbleitermoduls aus. Vorzugsweise ist das Substrat von einem Kunststoffgehäuse überdeckt, das auch die weiteren internen Komponenten des Leistungshalbleitermoduls umschließt und elektrisch gegen Berührung isoliert.

Das Substrat selbst ist in bevorzugter Weise derart ausgebildet, dass seine dem Inneren des Leistungshalbleitermoduls abgewandte Seite elektrisch von der internen Schaltung isoliert ist und nur der Wärmeabfuhr zu einer Kühleinrichtung dient. Für diese Ausgestaltung sind besonders beidseitig kupferkaschierte Substrate bevorzugt, wobei die dem Inneren des Leistungshalbleitermoduls zugewandte Kupferkaschierung in sich strukturiert ist und so die Leiterbahnen der Schaltung ausbildet. Die äußere Kupferkaschierung dient vornehmlich der effizienten Wärmeabgabe und bildet somit eine Außenseite, meist die Grundfläche, des Leistungshalbleitermoduls aus.

Das erfindungsgemäße Leistungshalbleitermodul weist auf dem mindestens einen Substrat eine Mehrzahl von konzentrisch um einen Mittelpunkt dieses Substrats angeordneten Leiterbahngruppen auf. Hierbei wird unter einer Leiterbahngruppe eine Anordnung von zwei Leiterbahnen zur Führung unterschiedlichen Potentials verstanden.

Auf zwei Leiterbahnen unterschiedlichen Potentials einer gemeinsamen Leiterbahngruppe ist jeweils mindestens ein Leistungshalbleiterbauelement vorgesehen. Beispielhaft im Fall der Halbbrückenschaltung sind zwei Leiterbahnen mit den Gleichspannungspotentialen unterschiedlichen Vorzeichens und eine weitere Leiterbahn mit Wechselspannungspotential vorgesehen. Ein erster Halbleiterschalter, vorzugsweise ausgebildet aus einer Antiparallelschaltung von bipolaren Leistungstransistoren und Leistungsdioden, ist hierbei auf der Leiterbahn positiven Gleichspannungspotentials angeordnet, ein zweiter Halbleiterschalter auf der Leiterbahn mit Wechselpotential. Die schaltungsgerechten Verbindungen zur Ausbildung der Halbbrückenschaltung sind mittels modulinterner Verbindungseinrichtungen, beispielhaft ausgestaltet als Drahtbondverbindungen, ausgebildet.

Alternativ sind selbstverständlich auch andere Leistungshalbleiterbauelemente wie Thyristoren oder Feldeffektransistoren vorsehbar, wodurch auch fast beliebige andere Schaltungstopologien verwirklicht werden können.

Das Substrat ist scheibenfömig mit einer kreisförmigen Grundfläche ausgebildet, und die Leiterbahngruppen bilden Kreissektoren dieses Substrats aus. Hierbei ist es besonders bevorzugt, wenn genau drei, ein kleines Vielfaches von zwei oder genau fünf Kreissektoren vorgesehen sind. Durch diese Ausgestaltung wird ein besonders kompakter Aufbau des Leistungshalbleitermoduls erreicht.

Weiterhin ist es vorteilhaft, wenn alle Leiterbahngruppen gleichartig, in gleicher geometrischer Ausgestaltung ausgebildet und gegeneinander verdreht angeordnet sind. Hierzu sind beispielhaft die Leiterbahnen eines Kreissektors, also einer Leitbahngruppe, auf denen die Leistungshalbleiterbauelemente angeordnet sind als radial aufeinander folgende Sektorsegmente ausgebildet. Hierbei werden die Leistungshalbleiterbauelemente der jeweiligen Sektorsegmente besonders wirksam gekühlt.

Weiterhin weist das Leistungshalbleitermodul den Potentialen des Substrats zugeordnete Lastanschlusselemente auf, die jeweils einen Grundkörper und mindestens ein Kontaktelement aufweisen. Mindestens zwei, vorzugsweise diejenigen des positiven und des negativen Gleichspannungspotentials, dieser Grundkörper der Lastanschlusselemente sind konzentrisch zueinander und zu dem Mittelpunkt des Substrats angeordnet. Darüber hinaus ist es bevorzugt, wenn der jeweilige Grundkörper zylindersymmetrisch, vorzugsweise als Hohlzylinder, ausgebildet ist. Durch diese innere Stromführung in den nahe benachbarten Grundkörper, sind die durch den Stromfluss, beispielhaft während der Kommutierungsphase einer Halbbrücke, erzeugten parasitären Induktivitäten besonders gering. Dies ermöglicht zudem eine effiziente Stromführung hoher Stromtragfähigkeit.

Das mindestens eine Kontaktelement ist vorzugsweise einstückig mit dem Grundkörper ausgebildet und verbindet das Lastanschlusselement elektrisch leitend mit einer zugeordneten Leiterbahn oder mit mindestens einem auf einer Leiterbahn angeordneten Leistungshalbleiterbauelement. Vorzugsweise weist jedes Lastanschlusselement eine externe Verbindungseinrichtung auf, die aus einem Teil des Lastanschlusselements selbst sowie aus einer Kontakteinrichtung, beispielhaft in Form einer Schraubverbindung, besteht.

Es ist weiterhin vorteilhaft, wenn das Substrat eine zentrale Ausnehmung aufweist. Dies ist vor allem dann vorteilhaft, wenn die Lastanschlusselemente, konkret deren Kontaktelemente, kraftschlüssig mit der mindestens einen Kontaktfläche des Substrat oder der Leistungshalbleiterbauelemente verbunden sind. Hierbei ist es mittels einer durch die zentrale Ausnehmung hindurch reichenden druckeinleitenden Einrichtung der Druckeinrichtung möglich die Druckkraft auf die Lastanschlusselemente und damit deren kraftschlüssigen Kontakt symmetrisch zum Mittelpunkt einzuleiten. Dies ist besonders für die gleichmäßige Kühlung des Substrats und der hierauf angeordneten Leistungshalbleiterbauelemente über eine vorsehbare Kühleinrichtung bevorzugt.

Alternativ zur kraftschlüssigen Verbindung der Lastanschlusselemente mit den Leiterbahnen des Substrats oder mit auf derartigen Leiterbahnen angeordnete Leistungshalbleiterbauelementen kann ebenso eine stoffschlüssige Verbindung, beispielhaft mittels Lötens oder Drucksinterns, vorteilhaft sein.

Die erfinderische Lösung wird an Hand der Ausführungsbeispiele der Fig. 1 bis 4 weiter erläutert.
Fig. 1 zeigt schematisch eine Halbbrückenschaltung.
Fig. 2 zeigt eine erste Ausgestaltung eines Leistungshalbleitermoduls in Draufsicht.
Fig. 3 zeigt eine Ausgestaltung eines erfindungsgemäßen Leistungshalbleitermoduls in Draufsicht.
Fig. 4 zeigt die Ausgestaltung des erfindungsgemäßen Leistungshalbleitermoduls im Querschnitt.

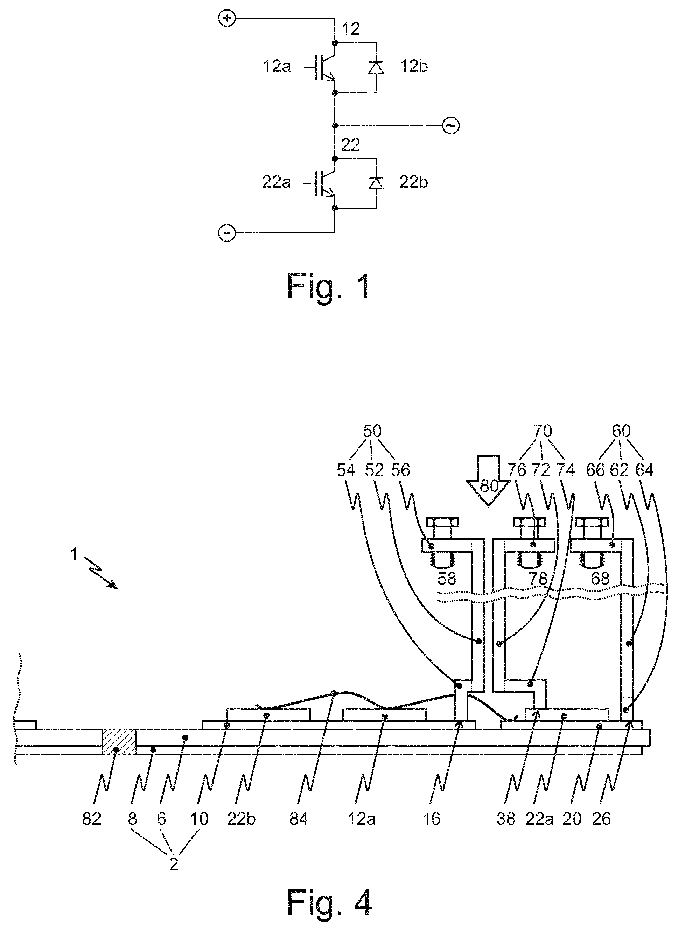

Fig. 1 zeigt schematisch eine Halbbrückenschaltung mit einem ersten und einem zweiten Leistungsschalter (12, 22), wobei dieser jeweils als ein bipolarer Transistor (12a, 22a) mit einer antiparallel geschalteten Diode (12b, 22b) ausgebildet ist. Selbstverständlich kann anstelle des einen Transistors auch eine Mehrzahl von parallel geschalteten Transistoren vorgesehen sein. Gleiches gilt für die Diode. Der erste Leistungsschalter (12) ist in dieser Schaltungstopologie zwischen mit dem positiven Gleichspannungspotential und dem Wechselpotential, dem Ausgang der Schaltung, geschaltet. Der zweite Leistungsschalter (22) ist zwischen Wechselpotential und negativem Gleichspannungspotential geschaltet.

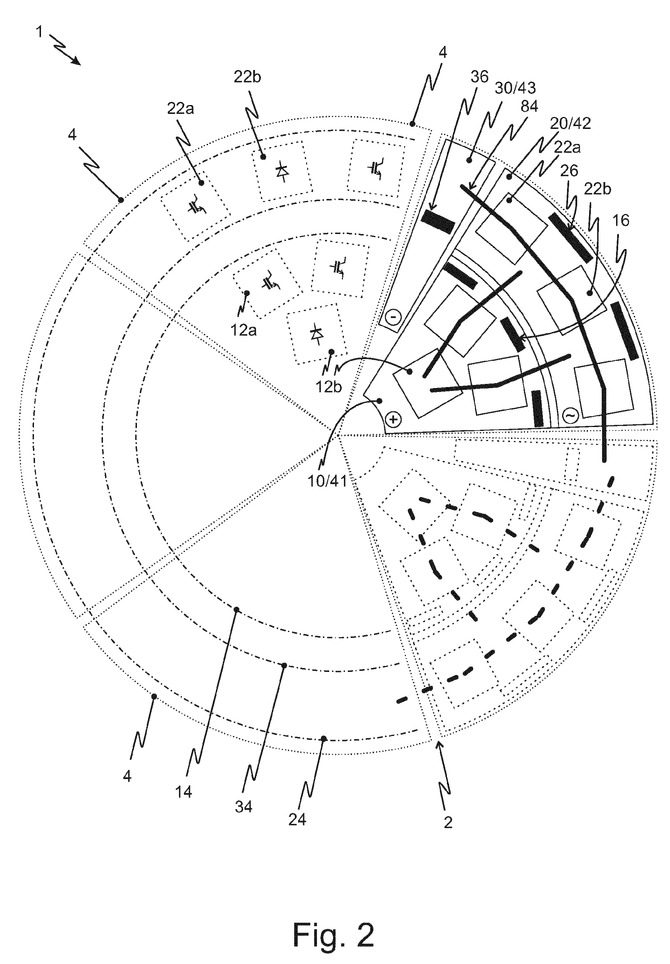

Fig. 2 zeigt eine Ausgestaltung eins Leistungshalbleitermoduls (1) mit einer Schaltungstopologie einer Halbbrückenschaltung, vgl. Fig. 1, in Draufsicht. Das Leistungshalbleitermodul (1) weist hier ein Substrat (2) mit fünf durch punktierte Linien angedeuteten Leiterbahngruppen (4) auf, wobei allerdings nicht in jeder Leiterbahngruppe alle Details dargestellt sind.

Das Substrat (2) ist hierbei ausgebildet als eine scheibenförmige Industriekeramik, auf der die Leiterbahnen (10, 20, 30) der Leiterbahngruppen (4) als Kupferkaschierungen ausgebildet sind. Jede Leiterbahngruppe (4) bildet einen Kreissektor, wobei jeder der fünf Kreissektoren grundsätzlich gleichartig, d.h. in gleicher geometrischer Ausgestaltung ausgebildet ist. Die fünf Kreissektoren sind gegeneinander verdreht angeordnet und bilden damit einen Gesamtkreis aus.

Jede Leiterbahngruppe (4) besteht ihrerseits aus drei Leiterbahnen (10, 20, 30) unterschiedlichen Potentials, wobei in einem ersten Sektorsegment (41) der Leiterbahngruppe (4), das sich unmittelbar an den Mittelpunkt des Substrats (2) anschließt, diejenige Leiterbahn (10) mit positivem Gleichspannungspotential angeordnet ist. In einem radial nachfolgenden Sektorsegment (42) ist die Leiterbahn (20) mit Wechselpotential angeordnet, während seitlich zu den beiden radial aufeinander folgenden Sektorsegmenten (41, 42) in einem weiteren Sektorsegment (43) diejenige Leiterbahn (30) mit negativem Gleichspannungspotential angeordnet ist.

Auf der Leiterbahn (10) mit positivem Gleichspannungspotential sind ein erster Leistungsschalter (12), vgl. Fig. 1, in Ausgestaltung von zwei parallel geschalteten bipolaren Leistungstransistoren (12a), und eine antiparallel hierzu geschaltete Leistungsdiode (12b) angeordnet. Auf der Leiterbahn (20) mit Wechselspannungspotential ist ein zweiter Leistungsschalter (22), vgl. Fig. 1, in gleicher Ausgestaltung wie der erste angeordnet. Zur schaltungsgerechten Verbindung der Leistungshalbleiterbauelemente (12 a/b, 22 a/b) untereinander bzw. mit einer Leiterbahn (20) ist als modulinterne Verbindungseinrichtung eine Mehrzahl von Drahtbondverbindungen (84), die nur angedeutet dargestellt sind, vorhanden.

Um eine symmetrische Stromverteilung zu erzielen, ist es hier durchaus vorteilhaft den jeweils zweiten Leistungsschalter (22) einer Leiterbahngruppe (4) nicht nur innerhalb dieser, sondern auch mit einer Leiterbahn mit negativem Gleichspannungspotential der benachbarten Leiterbahngruppe zu verbinden.

Das Substrat (2) ist somit zylindersymmetrisch um eine Gerade durch dessen Mittelpunkt ausgebildet. Diese Ausgestaltung ist besonders geeignet um Lastanschlusselemente (50, 60, 70) vorzusehen, die alle konzentrisch um den Mittelpunkt des Substrats (2) herum angeordnet sind. Diese Lastanschlusselemente (50, 60, 70) weisen hierzu jeweils einen Grundkörper (52, 62, 72) auf, der als Hohlzylinder ausgebildet ist. Die Positionen der jeweiligen Hohlzylinder sind durch die strichpunktierten Linien (14, 24, 34) dargestellt. Jedes dieser Lastanschlusselemente (50, 60, 70) weist weiterhin mindestens ein Kontaktelement (54, 64, 74) auf, das mit einer zugeordneten Kontaktfläche (16, 26, 36) der zugeordneten Leiterbahn (10, 20,30) elektrisch leitend verbunden ist.

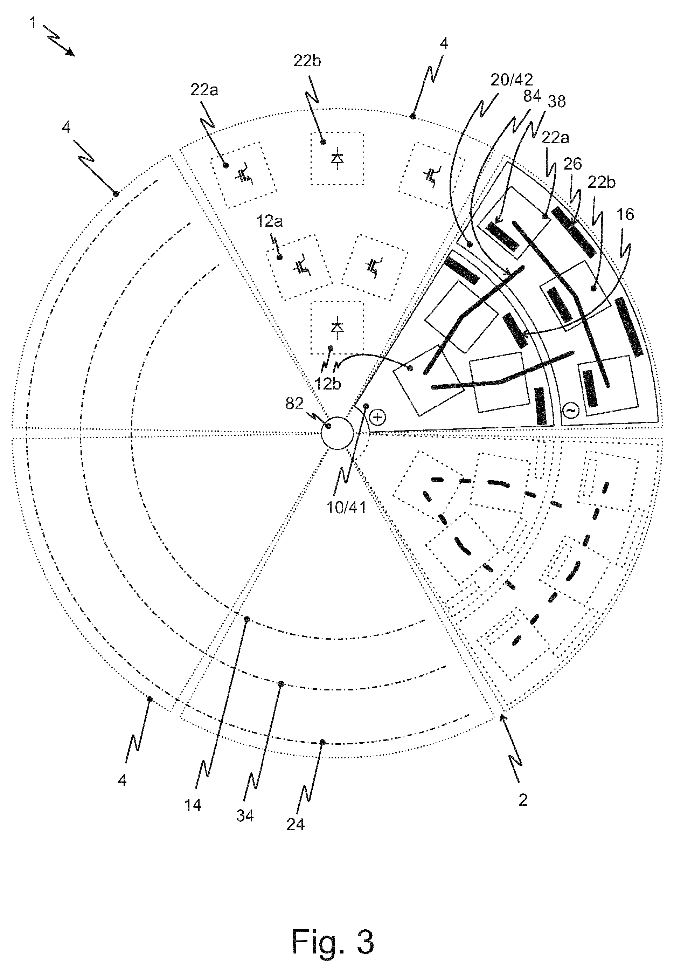

Fig. 3 zeigt eine Ausgestaltung eines erfindungsgemäßen Leistungshalbleitermoduls (1) in Draufsicht und analoger Darstellungsweise zu Fig. 2, während Fig. 4 diese zweite Ausgestaltung im Querschnitt zeigt. Dieses Leistungshalbleitermodul (1) weist wiederum ein scheibenförmiges Substrat (2) mit kreisrunder Grundfläche auf.

Das Substrat (2) weist in dieser Ausgestaltung sechs Leiterbahngruppen (4) auf, die als Kreissektoren ausgebildet sind, wie durch die punktierten Linien angedeutet. Jede dieser Leiterbahngruppen (4) besteht aus zwei radial aufeinander folgenden Sektorsegmenten (41, 42) mit annähernd gleichem Flächeninhalt, wodurch die Verlustleistung der Leistungshalbleiterbauelemente (12 a/b, 22 a/b) in Form von Abwärme jeweils auch auf die gleiche Fläche verteilt wird und in eine an der Unterseite des Substrats (2) anordenbare Kühleinrichtung abgegeben werden kann. Hierzu dient auch die Kupferkaschierung (8) auf der dem Inneren des Leistungshalbleitermoduls (1) abgewandten Seite des Substrats (2), das im Übrigen aus einer scheibenförmigen Industriekeramik (6), wie beispielhaft Aluminiumoxid, besteht. Auf der dem Inneren des Leistungshalbleitermoduls (1) zugewandten Seite des Substrats (2) ist ebenfalls eine, allerdings in sich strukturierte, Kupferkaschierung vorgesehen, die die Leiterbahnen (10, 20, 30) ausbildendet.

Jede der sechs Leiterbahngruppen (4) ist in ihrer grundsätzlichen geometrischen Ausgestaltung identisch, allerdings sind diese jeweils um 60° verdreht zueinander ausgebildet und auf dem scheibenförmigen Substrat (2) angeordnet.

Die jeweilige Leiterbahngruppe (4) besteht hier nur aus zwei Leiterbahnen (10, 20), einer mit positivem Gleichspannungspotential und einer mit Wechselspannungspotential, wobei auf beiden jeweils ein Leistungsschalter (12, 22), vgl. Fig. 1, ausgebildet mit zwei Bipolartransistoren (12a, 22a) und einer Leistungsdiode (12b, 22b), angeordnet ist. Die schaltungsgerechte Verbindung dieser Leistungshalbleiterbauelemente (12 a/b, 22 a/b) erfolgt beispielhaft wiederum mittels Drahtbondverbindungen (84), wobei selbstverständlich auch andere interne Verbindungseinrichtungen vorsehbar und möglicherweise vorteilhaft sind.

Die Lastanschlusselemente (50, 60, 70) sind grundsätzlich identisch denjenigen gemäß Fig. 2 ausgebildet und weisen einen als Hohlzylinder ausgebildeten Grundkörper (52, 62, 72) auf, der dem Substrat (2) zugewandt jeweils mindestens ein Kontaktelement (54, 64, 74) aufweist. Die dem positiven Gleichstrompotential und dem Wechselstrompotential zugeordneten Lastanschlusselemente (50, 60) weisen jeweils eine Mehrzahl von Kontakteinrichtungen (52, 62) auf, die mit Kontaktflächen (16, 26) der zugeordneten Leiterbahnen (10, 20) elektrisch leitend verbunden sind.

Das dem negativen Gleichstrompotential zugeordnete Lastanschlusselement (70) weist ebenfalls eine Mehrzahl von Kontakteinrichtungen (72) auf, die allerdings jeweils mit einer Kontaktfläche (38) der auf der Leiterbahn (20) mit Wechselspannungspotential angeordneten Leistungshalbleiterbauelementen (22 a/b) elektrisch leitend verbunden sind. Hierzu können diese Leistungshalbleiterbauelemente (22 a/b) eine besonders geeignet ausgestaltete Oberfläche, beispielhaft in Form einer besonders dicken Kontaktmetallschicht, aufweisen.

Die Grundkörper (52, 72) der den Gleichspannungspotentialen zugeordneten Lastanschlusselemente (50, 70) sind konzentrisch um den Mittelpunkt des Substrats (2) und eng benachbart zueinander angeordnet. Um diese eng benachbarte Anordnung ausbilden zu können, sind hier die Kontakteinrichtungen (52, 72) beider genannten Lastanschlusselemente (50, 70) gekröpft, wobei diese Kröpfung nahe dem Substrat (2) vorgesehen ist um insgesamt die stromumflossene Fläche zwischen den Lastanschlusselementen (50, 70) und damit die parasitären Induktivitäten klein zu halten.

Die Kontaktelemente (62) des dem Wechselspannungspotential zugeordneten Lastanschlusselements (60) sind hier ohne derartige Kröpfung ausgebildet.

Die Höhe der jeweiligen als Hohlzylinder ausgebildeten Grundkörper (52, 62, 72) ist grundsätzlich in weiten Grenzen beliebig und ist in den meisten vorteilhaften Fällen deutlich geringer als der Radius des Substrats (2).

Die jeweiligen Lastanschlusselemente (50, 60, 70) weisen weiterhin externe Verbindungseinrichtungen (56, 66, 76) auf, die hier beispielhaft als einstückig mit dem Grundkörper (52, 62, 72) verbundene parallel zum Substrat (2) vorgesehene Abschnitte ausgebildet sind. Diese Abschnitte weisen jeweils eine Ausnehmung zur Durchführung einer Schraube (58, 68, 78) zur Verbindung mit einer Schraubaufnahme, die beispielhaft in einem nicht dargestellten Gehäuse angeordnet sein kann, auf. Andere Verbindungsvarianten sind selbstverständlich alternativ vorsehbar.

Die elektrisch leitende Verbindung der Kontakteinrichtungen (52, 62, 72) der Lastanschlusselemente (50, 60, 70) mit den Kontaktflächen (16, 26) der Leiterbahnen (10, 20) oder mit Kontaktflächen (38) von Leistungshalbleiterbauelementen (22 a/b) kann mittels stoffschlüssiger Verfahren ausgebildet sein. In der dargestellten Ausgestaltung ist diese Verbindung mittels eines kraftschlüssigen Verfahrens ausgebildet. Hierzu weist das Leistungshalbleitermodul eine Druckeinrichtung (80) auf, die auf die Lastanschlusselemente (50, 60, 70) in Richtung des Substrats (2) Druck einleitet.

Hierzu weist das Substrat (2) eine zentrale Ausnehmung (82) auf, wodurch eine druckkrafterzeugende Einrichtung der Druckeinrichtung (80) hindurch zu einer Grundplatte oder einer Kühleinrichtung reicht.

## Patentansprüche

1. Leistungshalbleitermodul (1) mit mindestens einem Substrat (2) mit einer Mehrzahl von in konzentrisch um einen Mittelpunkt des Substrats angeordneten Leiterbahngruppen (4), wobei
das Substrat (2) scheibenförmig ausgebildet ist und die Leiterbahngruppen (4) als Kreissektoren ausgestaltet sind, wobei je Leiterbahngruppe (4) zwei Leiterbahnen (10, 20) zur Führung unterschiedlichen Potentials vorgesehen sind, wobei die Leiterbahnen zwei radial aufeinanderfolgende Sektorsegmente mit annähernd gleichem Flächeninhalt ausbilden und auf den zwei Leiterbahnen (10, 20) unterschiedlichen Potentials jeweils mindestens ein Leistungshalbleiterbauelement (12 a/b, 22 a/b) vorgesehen ist, mit mindestens zwei Lastanschlusselementen (50, 60, 70) jeweils mit einem Grundkörper (52, 62, 72) und mindestens einem Kontaktelement (54, 64, 74), wobei die Grundkörper (52, 62, 72) konzentrisch zueinander und zu dem Mittelpunkt des Substrats (2) sowie eng benachbart zueinander angeordnet sind, und wobei das jeweils mindestens eine Kontaktelement (54, 64, 74) in elektrisch leitendem Kontakt zu Kontaktflächen (16, 26) einer zugeordneten Leiterbahnen (10, 20) oder zu Kontaktflächen (38) mindestens eines auf einer Leiterbahn (20) angeordneten Leistungshalbleiterbauelement (22a, 22b) steht.

2. Leistungshalbleitermodul nach Anspruch 1, wobei
das mindestens eine Leistungshalbleiterbauelement ausgebildet ist als Thyristor, eine Diode, Feldeffekttransistor, oder als Kombination aus Bipolartransistor (12a, 22a) und antiparallel geschalteter Diode (12b, 22b).

3. Leistungshalbleitermodul nach Anspruch 1, wobei
der Grundkörper (52, 62, 72) mindestens eines Lastanschlusselements (50, 60, 70) als Hohlzylinder mit einstückig hiermit verbundenen Kontaktelementen (52, 62, 72) ausgebildet ist.

4. Leistungshalbleitermodul nach Anspruch 1, wobei
die Grundkörper (52, 72) der einem positiven und einem negativen Potential zugeordneten Lastanschlusselemente (50, 70) eng benachbart und elektrisch isoliert zueinander angeordnet sind.

5. Leistungshalbleitermodul nach Anspruch 1, wobei
die Lastanschlusselemente (50, 60, 70) zusätzlich externe Verbindungseinrichtungen (56, 66, 76) aufweisen.

6. Leistungshalbleitermodul nach Anspruch 1, wobei
alle Leiterbahngruppen (4) gleichartig, in gleicher geometrischer Ausgestaltung ausgebildet und gegeneinander verdreht angeordnet sind.

7. Leistungshalbleitermodul nach Anspruch 1, wobei
das Substrat (2) eine zentrale Ausnehmung (82) aufweist,

8. Leistungshalbleitermodul nach Anspruch 7, wobei
die Lastanschlusselemente kraftschlüssig mit dem Substrat oder den Leistungshalbleiterbauelementen verbunden sind und mittels einer durch die zentrale Ausnehmung (82) hindurch reichenden druckkrafterzeugenden Einrichtung der Druckeinrichtung (80) Druck auf die Lastanschlusselemente (50, 60, 70) zu deren kraftschlüssigem Kontakt zu den Kontaktflächen (16, 26, 36, 38) eingeleitet wird.

## Claims

1. Power semiconductor module (1) comprising at least one substrate (2) with a plurality of conductor track groups (4) arranged in concentrically around a midpoint of the substrate, wherein the substrate (2) is embodied in a disc-shaped fashion and the conductor track groups (4) are configured as circle sectors, wherein two conductor tracks (10, 20) for carrying different potentials are provided per conductor track group (4), wherein the conductor tracks form two radially successive sector segments having an approximately identical area content and in each case at least one power semiconductor component (12 a/b, 22 a/b) is provided on the two conductor tracks (10, 20) having different potentials, comprising at least two load connection elements (50, 60, 70) each having a base body (52, 62, 72) and at least one contact element (54, 64, 74), wherein the base bodies (52, 62, 72) are arranged concentrically with respect to one another and with respect to the midpoint of the substrate (2) and also closely adjacent to one another, and wherein the at least one contact element (54, 64, 74) in each case is in electrically conductive contact with contact areas (16, 26) of an assigned conductor tracks (10, 20) or with contact areas (38) of at least one power semiconductor component (22a, 22b) arranged on a conductor track (20).

2. Power semiconductor module according to Claim 1, wherein
the at least one power semiconductor component is embodied as a thyristor, a diode, a field effect transistor, or as a combination of bipolar transistor (12a, 22a) and diode (12b, 22b) reverse-connected in parallel.

3. Power semiconductor module according to Claim 1, wherein
the base body (52, 62, 72) of at least one load connection element (50, 60, 70) is embodied as a hollow cylinder with contact elements (52, 62, 72) integrally connected thereto.

4. Power semiconductor module according to Claim 1, wherein
the base bodies (52, 72) of the load connection elements (50, 70) assigned to a positive and a negative potential are arranged in a manner closely adjacent to, and electrically insulated from, one another.

5. Power semiconductor module according to Claim 1, wherein
the load connection elements (50, 60, 70) additionally have external connecting devices (56, 66, 76).

6. Power semiconductor module according to Claim 1, wherein
all the conductor track groups (4) are embodied in an identical fashion, with an identical geometrical configuration, and are arranged in a manner rotated relative to one another.

7. Power semiconductor module according to Claim 1, wherein
the substrate (2) has a central cutout (82).

8. Power semiconductor module according to Claim 7, wherein
the load connection elements are connected to the substrate or the power semiconductor components in a force-locking manner and, by means of a compressive-force-generating device of the pressure device (80) that extends through the central cutout (82), pressure is introduced onto the load connection elements (50, 60, 70) for the force-locking contact thereof with the contact areas (16, 26, 36, 38).

## Revendications

1. Module semi-conducteur de puissance (1) doté d'au moins un substrat (2) avec une pluralité de groupes de pistes conductrices (4) disposées en concentriquement autour d'un point central du substrat, dans lequel
le substrat (2)est réalisé en forme de disque et les groupes de pistes conductrices (4) sont conçus comme des secteurs de cercle, dans lequel deux pistes conductrices (10, 20) sont prévues par groupe de pistes conductrices (4) pour guider un potentiel différent, dans lequel les pistes conductrices réalisent deux segments de cercle se succédant radialement avec une aire approximativement identique et sur les deux pistes conductrices (10, 20) de potentiel différent respectivement au moins un élément semi-conducteur de puissance (12 a/b, 22 a/b) est prévu, avec au moins deux éléments de borne de charge (50, 60, 70) dotés respectivement d'un corps de base (52, 62, 72) et d'au moins un élément de contact (54, 64, 74), dans lequel les corps de base (52, 62, 72) sont disposés concentriquement les uns par rapport aux autres et par rapport au point central du substrat (2) ainsi qu'en proximité étroite les uns des autres, et dans lequel respectivement l'au moins un élément de contact (54, 64, 74) se trouve en contact électriquement conducteur avec les surfaces de contact (16, 26) d'une pistes conductrice coordonnée (10, 20) ou avec les surfaces de contact (38) d'au moins un élément semi-conducteur de puissance (22a, 22b) disposé sur une piste conductrice (20).

2. Module semi-conducteur de puissance selon la revendication 1, dans lequel l'au moins un élément semi-conducteur de puissance est conçu comme un thyristor, une diode, un transistor à effet de champ ou comme combinaison d'un transistor bipolaire (12a, 22a) et d'une diode branchée de manière antiparallèle (12b, 22b).

3. Module semi-conducteur de puissance selon la revendication 1, dans lequel le corps de base (52, 62, 72) d'au moins un élément de borne de charge (50, 60, 70) est conçu comme un cylindre creux avec des éléments de contact (52, 62, 72) qui lui sont reliés en un seul tenant.

4. Module semi-conducteur de puissance selon la revendication 1, dans lequel les corps de base (52, 72) d'un élément de borne de charge (50, 70) coordonnée à un potentiel positif et négatif sont disposés en proximité étroite et isolés électriquement les uns des autres.

5. Module semi-conducteur de puissance selon la revendication 1, dans lequel les éléments de borne de charge (50, 60, 70) présentent en outre des dispositifs de liaison externes (56, 66, 76).

6. Module semi-conducteur de puissance selon la revendication 1, dans lequel tous les groupes de pistes conductrices (4) sont conçus identiquement, dans une configuration géométrique similaire et sont disposés en étant tournés les uns contre les autres.

7. Module semi-conducteur de puissance selon la revendication 1, dans lequel le substrat (2) présente un évidement central (82).

8. Module semi-conducteur de puissance selon la revendication 7, dans lequel les éléments de borne de charge sont reliés par conjonction de force avec le substrat ou les éléments semi-conducteurs de puissance et au moyen d'un dispositif de production de pression (80) générant une force de pression passant à travers l'évidement central (82) une pression est exercée sur les éléments de borne de charge (50, 60, 70) en vue de leur contact par conjonction de force avec les surfaces de contact (16, 26, 36, 38).
